# EUROPÄISCHE PATENTSCHRIFT

(11) **EP 0 619 498 B1**
(45) Veröffentlichungstag und Bekanntmachung des Hinweises auf die Patenterteilung: **04.12.2002**
(21) Anmeldenummer: 94200823.6
(22) Anmeldetag: 29.03.1994
(51) Int. Cl.: G01R 33/28, G01R 33/56, A61M 25/00, A61B 5/055

(54) **MR-Abbildungsverfahren und Anordnung zur Durchführung des Verfahrens**
Magnetic resonance imaging method and device for carrying out the method
Procédé pour la formation d'images par résonance magnétique et dispositif pour la mise en oeuvre du procédé

(30) Priorität: 03.04.1993 DE 4310993
(43) Veröffentlichungstag der Anmeldung: 12.10.1994
(73) Patentinhaber: Philips Corporate Intellectual Property GmbH, 20099 Hamburg (DE); Koninklijke Philips Electronics N.V., 5621 BA Eindhoven (NL)
(72) Erfinder: Kuhn, Michael Harald, Dr., D-20097 Hamburg (DE)
(74) Vertreter: Hartmann, Heinrich, Dipl.-Ing.

(56) Entgegenhaltungen:
- EP-A- 0 165 742
- EP-A- 0 488 496
- WO-A-85/02264
- DE-A- 3 918 625
- US-A- 4 835 690
- US-A- 5 155 435
- US-A- 5 188 111
- IEEE TRANSACTIONS ON MEDICAL IMAGING, Bd.11, Juni 1992, NEW YORK, USA Seiten 203 - 214 J.L. SCHIANO ET AL.: 'Feedback Control of the Nuclear Magnetization State: Experimental Results'
- HOLSINGER: 'Real- Time Interactive MRI' MAGNETIC RESONANCE IN MEDICINE Bd. 14, Nr. 3, Juni 1990, DULUTH, Seiten 547 - 553

## Beschreibung

Die Erfindung betrifft ein MR-Verfahren nach dem Oberbegriff des Anspruchs 1. Außerdem betrifft die Erfindung eine Anordnung zur Durchführung des Verfahrens.

Derartige Verfahren und zu ihrer Durchführung geeignete MR-Anordnungen sind in großer Zahl bekannt. Der zeitliche Verlauf der Hochfrequenzimpulse (u.a. ihre Mittenfrequenz, ihre Umhüllende und ihre Amplitude) kann dabei vom Benutzer ebenso vorgegeben werden wie der zeitliche Verlauf der magnetischen Gradientenfelder (beispielsweise deren Dauer und Amplitude sowie ihre zeitliche Lage in bezug auf den oder die Hochfrequenzimpulse). Wenn diese Daten vom Benutzer aber einmal festgelegt sind, beispielsweise dadurch, daß er ein bestimmtes Untersuchungsverfahren auswählt und das sogenannte "field of view", dann ist der zeitliche Verlauf der Hochfrequenzimpulse und der magnetischen Gradientenfelder bei den nachfolgenden Sequenzen vorbestimmt. Ob damit optimale Ergebnisse erreicht werden, hängt u.a. davon ab, ob der Benutzer die im Hinblick auf die diagnostische Fragestellung optimale Wahl der Parameter getroffen hat.

Aufgabe der vorliegenden Erfindung ist es, die Möglichkeiten für die Optimierung zu erweitern. Diese Aufgabe wird durch die im Anspruch 1 angegebenen Maßnahmen gelöst. Bei der Erfindung gibt es also eine Rückwirkung (Feedback) von den aus den MR-Signalen rekonstruierten MR-Bildern auf den zeitlichen Verlauf der Hochfrequenzimpulse und/oder der magnetischen Gradientenfelder, die ihrerseits bei den nachfolgenden Sequenzen die MR-Signale bzw. das MR-Bild bestimmen. Durch diesen Prozeß lassen sich bestimmte vom Benutzer gewünschte Eigenschaften des MR-Verfahrens optimieren, weil das MR-Bild in dieser Hinsicht analysiert wird und der zeitliche Verlauf der Hochfrequenzimpulse und der magnetischen Gradientenfelder für das weitere MR-Verfahren in Abhängigkeit von dem Analyseresultat gesteuert wird.

Es sei an dieser Stelle erwähnt, daß Verfahren mit einem feedback an sich bekannt sind, beispielsweise aus der EP-OS 439 119, bei der die HF-Leistung dadurch gesteuert wird. Grundlage dieser Verfahren ist aber stets die Analyse einzelner MR-Signale und nicht die Analyse eines aus einer Anzahl solcher Signale zusammengesetzten MR-Bildes.

Es sei weiter erwähnt, daß aus der DE-A1-39 18 625 ein MR-Verfahren bekannt ist, bei dem zunächst ein MR-Bild des Herzens in verschiedenen Phasen der Herzaktion ermittelt wird. Aus diesem Bild wird - manuell oder automatisch - eine Tabelle bestimmt, die die Lage der Aortenwurzel des Herzens in den verschiedenen Phasen der Herzaktion angibt. Anschließend werden die Herzkranzgefäße in verschiedenen Phasen der Herzaktion in einem sog. "Time of Flight"-Verfahren abgebildet, indem die Kernmagnetisierung der Aortenwurzel an der für die jeweilige Herzphase aus der Tabelle entnehmbaren Position angeregt und die MR-Signale ausgewertet werden. Eine Regelschleife im Sinne der Erfindung gibt es hierbei nicht, weil der zeitliche Verlauf aller nachfolgenden Sequenzen ausschließlich von der zu Beginn erzeugten Tabelle bestimmt werden.

Eine Anordnung zur Durchführung des erfindungsgemäßen Verfahrens ist versehen mit
a) einer Gradientenspulenanordnung zur Erzeugung von magnetischen Gradientenfeldern in einem von einem stationären homogenen Magnetfeld durchsetzten Untersuchungsbereich,
b) einer Hochfrequenzspulenanordnung zum Erzeugen eines hochfrequenten Magnetfeldes bzw. zum Empfang von MR-Signalen aus dem Untersuchungsbereich,
c) Mitteln zum Analysieren eines aus einer Anzahl von MR-Signalen rekonstruierten MR-Bildes,
d) Mitteln zur Steuerung der Gradientenspulenanordnung und/oder der Hochfrequenzspulenanordnung für die nachfolgenden Sequenzen in Abhängigkeit von dem Analyseresultat und
f) Mitteln zur Wiedergabe des daraus resultierenden MR-Bildes.

Die Mitttel zur Steuerung des zeitlichen Verlaufs der Ströme in der Gradientenspulenanordnung bzw. der Hochfrequenzspulenanordnung schließen also eine Schleife, die vom Untersuchungsbereich über die Hochfrequenzempfangsspule bis zu der auf den Untersuchungsbereich einwirkenden Gradientenspulenanordnung bzw. Hochfrequenzspulenanordnung reicht.

Das erfindungsgemäße Verfahren läßt sich in vielfältiger Weise zur Beeinflussung von MR-Verfahren einsetzen; was dabei erreicht wird, hängt davon ab, welche Eigenschaften der MR-Bilder kontrolliert werden sollen. Im folgenden soll kurz auf einige Möglichkeiten eingegangen werden.

Eine Anwendungsmöglichkeit ist bei den sogenannten interventionellen Untersuchungen gegeben, bei denen medizinische Instrumente in einen Körper eingeführt und bis zu einer definierten anatomischen Region vorgeschoben werden. Bekanntestes Beispiel dafür ist die digitale Subtraktionsangiographie, bei der ein Katheter unter Durchleuchtungskontrolle durch die Gefäße bis zu einer Untersuchungsstelle, beispielsweise in die Nähe des Herzens, vorgeschoben wird, damit von dort aus Kontrastmittel in das Gefäß gespritzt werden kann (selektive Kontrastmittelinjektion). Ein Nachteil dieses Verfahrens ist die Belastung des Patienten und des Untersuchers durch Röntgenstrahlung. Bildgebende Verfahren auf MR-Basis haben diesen Nachteil zwar nicht, und sie geben darüberhinaus Weichteilkontraste in der Regel besser wieder als Röntgenbilder, jedoch ist es kaum möglich, damit eine der Röntgendurchleuchtung äquivalente Positionierungskontrolle zu schaffen, weil MR-Bilder nicht in so dichter zeitlicher Folge hintereinander erzeugt werden können wie Röntgenbilder.

Bei einem aus der US-PS 4,572,198 bekannten Verfahren der eingangs genannten Art ist ein Katheter vorgesehen, der an seiner Spitze eine Leiterschleife aufweist, die über zwei Folienleiter im Innern des Katheters an eine Impulsstromquelle anschließbar ist. Beim Einführen des Katheters werden MR-Bilder erzeugt, wobei die Impulsstromquelle abwechselnd ein- und ausgeschaltet wird. In diesen Bildern wird die Katheterspitze sichtbar, weil die Impulsstromquelle in diesem Bereich eine Feldverzerrung bewirkt. Allerdings wird dadurch das Auflösungsvermögen gerade im Bereich der Katheterspitze eingeschränkt, was von Nachteil ist, weil die anatomischen Strukturen in diesem Bereich - beispielsweise eine Gabelung der Arterie - für den Untersucher erkennbar bleiben sollen. Bildet man bei diesem Verfahren einen genügend großen Bereich ab, um dem Untersucher eine Orientierung zu geben, in welcher anatomischen Region des Körpers er sich befindet, können nur Bildfolgen mit zeitlichen Abständen von einigen Sekunden erzeugt werden. Dies ist im Vergleich zu einer Röntgendurchleuchtung, wo innerhalb einer Sekunde 20 oder mehr Bilder erzeugt werden können, langsam, so daß der gesamte Positioniervorgang mit dem bekannten Verfahren entsprechend langsam vor sich geht.

Ein anderes Verfahren wurde von Dumoulin, et al in dem Aufsatz "Tracking of an Invasive Device within an MR imaging system" (abgedruckt in 11. SMRM, Aug. 92, Book of Abstracts, S. 104) beschrieben. Dabei ist eine Hochfrequenzempfangsspule mit der Spitze eines Katheters verbunden, die lediglich aus ihrer unmittelbaren Umgebung MR-Signale empfangen kann. Während der Einführung des Katheters werden MR-Bilder auf der Basis von Gradientenechos erzeugt, wobei die Gradientenrichtung nach jedem Hochfrequenzimpuls in eine andere Richtung springt. Die Frequenz der während der Einwirkung der magnetischen Gradientenfelder empfangenen Kernresonanzsignale ist linear mit der Position der Hochfrequenzempfangsspule verknüpft, so daß durch eine eindimensionale Fouriertransformation dieser Signale die Katheterspitze lokalisiert werden kann. und zwar vergleichsweise schnell (z.B. 20 mal pro Sekunde). Diese Position wird in die MR-Bilder eingeblendet, die aus den mit einer weiteren Hochfrequenzempfangsspule empfangenen Gradientenechosignalen rekonstruiert werden. Auch hierbei ist es nur schwer möglich, einen Bereich, der genügend groß ist, um die anatomische Orientierung zu gestatten, mit einem Auflösungsvermögen, das zur Darstellung der feinen Strukturen von der Katheterspitze ausreicht, abzubilden, wenn die MR-Bilder in dichtem zeitlichen Abstand aufeinanderfolgen. Außerdem hat dieses Verfahren mit dem zuvor erwähnten Verfahren gemeinsam, daß der Kastheter, der aus hygenischen Gründen nur einmal benutzt werden kann, wegen der darin inkorporierten elektrischen Leiter relativ teuer ist.

Das erfindungsgemäße Verfahren gestattet die Positionskontrolle von der Diagnose oder der Therapie dienenden Gegenständen gemäß der Weiterbildung nach Anspruch 2.

Bei dieser Anwendung des der Erfindung zugrundeliegenden Prinzips wird also vor der Positionierung des Gegenstandes mit gutem MR-Kontrast, - vorzugsweise eines mit einem MR-Kontrastmittel gefüllten Katheters - ein MR-Übersichtsbild erzeugt. Dazu kann ein dreidimensionaler Datensatz aus dem Körperbereich gewonnen werden, innerhalb dessen der Positioniervorgang stattfindet, jedoch kann das MR-Übersichtsbild auch durch eine oder mehrere zweidimensionale Schichtaufnahmen gebildet werden. Dieses Bild kann relativ groß sein und ein gutes räumliches Auflösungsvermögen haben, weil zur Erzeugung der dafür erforderlichen MR-Datensätze vor der Positionierung genügend Zeit vorhanden ist. Es muß lediglich darauf geachtet werden, daß der Patient so fixiert ist, daß bis zur Positionierung Bewegungen und damit Lageänderungen gegenüber dem Übersichtsbild weitgehend vermieden werden.

Während der Einführung des mit einem Kontrastmittel gefüllten Katheters werden fortlaufend MR-Bilder eines Zielbereiches um und vor der Katheterspitze erzeugt, dessen Ausdehnung klein ist im Vergleich zu dem durch das Übersichtsbild abgebildeten Bereich. Wegen dieser geringen Abmessungen des Zielbereichs können die davon in dichter zeitlicher Folge erzeugten MR-Bilder ein genügend hohes Auflösungsvermögen haben, um die Spitze des - zur besseren Sichtbarmachung mit dem MR-Kontrastmittel gefüllten - Katheters gut abbilden zu können. Dieses MR-Bild wird in das MR-Übersichtsbild eingeblendet, so daß der Arzt einerseits die Lage zumindest der Katheterspitze gut erkennen kann und andererseits anhand des MR-Übersichtsbildes eine gute anatomische Orientierung hat.

Der Zielbereich muß jeweils seine Lage entsprechend der Lage der Katheterspitze verändern. Zu diesem Zweck wird - mit einem geeigneten Bildverarbeitungsverfahren - die Lage der Katheterspitze in dem MR-Bild des Zielbereichs automatisch ermittelt und daraus die Lage des Zielbereichs beim nächsten MR-Bild bestimmt. Die Lage des Zielbereichs wird durch die Mittenfrequenz der Hochfrequenzimpulse bestimmt. Diese muß also bei den Sequenzen für das nächste MR-Bild entsprechend geändert werden. Dementsprechend ändert das mit dem MR-Übersichtsbild kombinierte bzw. darin eingeblendete MR-Bild sowie die darin abgebildete Katheterspitze - fortlaufend seine Lage innerhalb des MR-Übersichtsbildes, so daß sich für den Untersucher ein Bildeindruck ergibt, der mit einer Röntgendurchleuchtung vergleichbar ist.

In einer bevorzugten Ausgestaltung der Erfindung die davon ausgeht, daß der Gegenstand ein mit einem Kontrastmittel gefüllter Katheter ist, ist vorgesehen, daß aus den MR-Bildern automatisch die Richtung der Katheterspitze ermittelt wird und daß in Abhängigkeit von dieser Richtung die Gradientenspulen zur Erzeugung der während der Einführung des Katheters wirksamen magnetischen Gradientenfelder so gesteuert werden, daß ein magnetisches Gradientenfeld entsprechend der Richtung der Katheterspitze und die anderen senkrecht dazu verlaufen. Diese Weiterbildung erlaubt die Ausführung des erfindungsgemäßen Verfahrens mit einem kleinen Zielbereichsvolumen, so daß es möglich ist, das Auflösungsvermögen des davon erstellten MR-Bildes und/oder die Folgefrequenz der MR-Bilder zu vergrößern, ohne daß die Gefahr besteht, daß die Katheterspitze den Zielbereich verläßt und nicht mehr abgebildet wird.

Bei verschiedenen Anwendungen kann es vorkommen, daß der Bereich, innerhalb dessen der Katheter verschoben werden soll, so groß ist, daß er nicht mit einem einzigen MR-Bild erfaßt werden kann. Eine hierfür vorgesehene Weiterbildung sieht vor, daß zur Erzeugung des MR-Übersichtsbildes der Körper in wenigstens zwei definierte Positionen geschoben und das MR-Übersichtsbild aus den dabei gewonnenen MR-Teilbildern zusammengesetzt wird und daß bei der Einführung des Katheters der Körper in die gleichen Positionen geschoben wird, derart, daß die verschiedenen Körperstrukturen jeweils bei der Erfassung des MR-Teilbildes einerseits und des MR-Bildes des Zielbereiches andererseits jeweils die gleiche Position einnimmt. Die MR-Teilbilder können dabei einem zwei- oder dreidimensionalen Datensatz entstammen. Da dabei die abgebildeten Körperstrukturen bei der Aufnahme der MR-Bilder der einzelnen Zielbereiche in der gleichen Position sind wie bei der Erzeugung der MR-Teilbilder für das MR-Übersichtsbild, ergeben sich bezüglich der Hauptfeldinhomogenität und der Gradientenlinearität identische Verhältnisse, so daß die dadurch hervorgerufenen Verzerrungen im MR-Übersichtsbild einerseits und in den MR-Bildern der Zielbereich andererseits jeweils gleich sind.

Eine Weiterbildung der Erfindung, die davon ausgeht, daß das Katheter in eine Arterie eingeführt wird, sieht vor, daß während des Einführens des Katheters die Kernmagnetisierung in dem Bereich hinter der Katheterspitze gesättigt wird. Wenn das Katheter in einer Arterie liegt, strömt innerhalb der Arterie Blut an dem Katheter vorbei. Dieses Blut kann in den gut aufgelösten MR-Bildern des Zielbereiches ebenfalls abgebildet werden, was die automatische Auswertung der MR-Bilder zur Ermittlung der Lage bzw. der Richtung der Katherterspitze erschwert. Dieser unerwünschte Einfluß wird dadurch zumindest vemindert, daß die Kernmagnetisierung in dem Bereich hinter der Katheterspitze gesättigt wird, so daß das Blut nicht mehr abgebildet wird, wenn es anschließend an der Katheterspitze vorbeiströmt.

Die Erfindung wird nachstehend anhand der Zeichnungen näher erläutert.
Es zeigen:
- Fig. 1: ein Kernspinuntersuchungsgerät zur Durchführung des erfindungsgemäßen Verfahrens,
- Fig. 2: ein Blockschaltbild eines solchen Gerätes,
- Fig. 3: den zeitlichen Verlauf verschiedener Signale bei einer für die Durchführung vorgesehen Sequenz,
- Fig. 4: ein Übersichtsbild des zu untersuchenden Körpers und
- Fig. 5: den Zielbereich in bezug auf die Arterie.

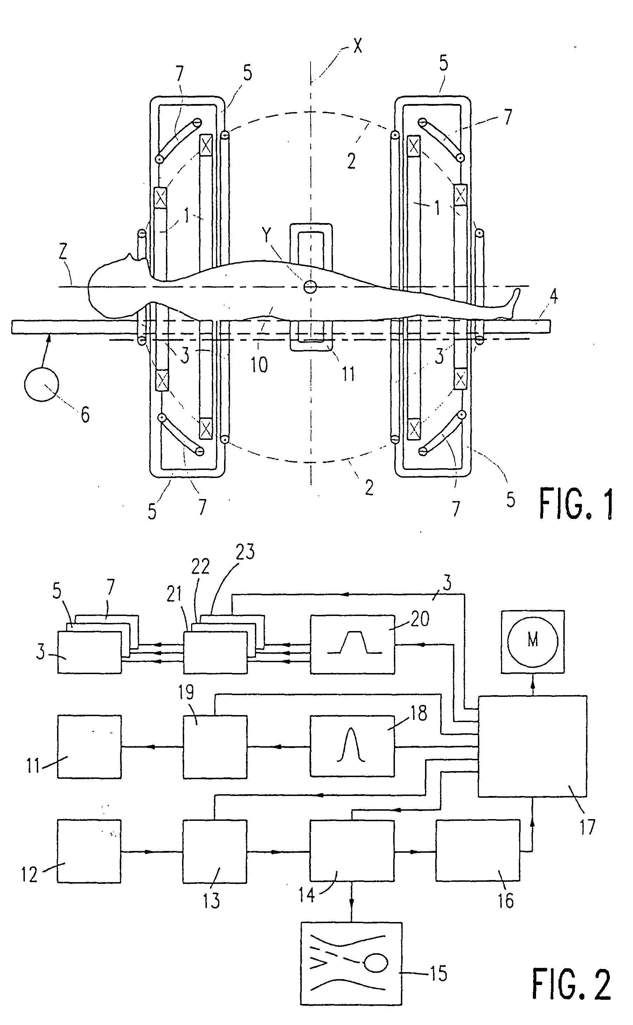

Das in Fig. 1 schematisch dargestellte Kernspinuntersuchungsgerät enthält eine aus vier Spulen 1 bestehende Anordnung zur Erzeugung eines homogenen stationären Magnetfeldes, das in der Größenordnung von einigen Zehntel T bis einigen T liegen kann. Die zur z-Achse konzentrisch angeordneten Spulen 1 können auf einer Kugelfläche 2 angeordnet sein. Im Innern dieser Spulen befindet sich der zu untersuchende Patient 10 auf einer Tischplatte 4, die mittels eines Motorantriebes 6 in Längsrichtung des Patienten, d.h. in z-Richtung verschiebbar ist.

Zur Erzeugung eines in z-Richtung verlaufenden und sich in dieser Richtung linear ändernden Magnetfeldes sind vier Spulen 3 auf der Kugeloberfläche 2 oder einer Zylinderoberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) erzeugen, dessen Gradient jedoch in x-Richtung (vertikal) verläuft. Ein in z-Richtung verlaufendes magnetisches Gradientenfeld mit einem Gradienten in y-Richtung (senkrecht zur Zeichenebene der Fig. 1) wird von vier Spulen 5 erzeugt, die mit den Spulen 7 identisch sein können, die jedoch diesen gegenüber um 90° räumlich versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder symmetrisch zur Kugeloberfläche 2 angeordnet ist, ist die Feldstärke im Kugelzentrum nur durch das stationäre homogene Magnetfeld der Spule 1 bestimmt.

Weiterhin ist eine Hochfrequenzspule 11 vorgesehen, die ein im wesentlichen homogenes und senkrecht zur Richtung des stationären homogenen Magnetfeldes (d.h. senkrecht zur z-Richtung) verlaufendes hochfrequentes Magnetfeld erzeugt. Der Hochfrequenzspule 11 wird während jedes Hochfrequenzimpulses ein hochfrequenter modulierter Strom von einem Hochfrequenzgenerator zugeführt. Die Hochfrequenzspule 11 könnte ebenfalls zum Empfangen der im Untersuchungbereich erzeugten Kernresonanzsignale dienen. Zweckmäßigerweise wird dafür jedoch eine gesonderte, in Fig. 1 nicht näher dargestellte Hochfrequenzempfangsspule verwendet.

Bei dem erfindungsgemäßen Verfahren wird von dem stabil auf dem Patientenlagerungstisch 4 gelagerten Patienten 10 ein Datensatz für ein MR-Übersichtsbild aufgenommen. Bei dem Datensatz kann es sich um einen zweidimensionalen Datensatz einer zur Tischplattenebene parallelen Schicht handeln, die so dick ist, daß sie die Arterien enthält, in der der Katheter verschoben werden soll, oder um einen dreidimensionalen Datensatz (vergl. US-PS 4,770,182), aus dem ein Übersichtsbild mit vorgebbarer Orientierung hergestellt werden kann.

Das Übersichtsbild sollte den gesamten Bereich des Patienten wiedergeben, innerhalb dessen der Katheter verschoben wird, beispielsweise den Bereich vom Oberschenkel bis zum Herzen. In der Regel kann man einen derart großen Bereich nicht mit einem einzigen MR-Übersichtsbild aufnehmen, weil das von den Spulen 1 erzeugte stationäre Magnetfeld nur in einem beschränkten Bereich die erforderliche Homogenität aufweist. Es müssen daher mehrere MR-Übersichtsbilder aufgenommen werden, beispielsweise je eins für den Oberschenkel-, den Abdominal- und den Herzbereich. Dabei sollte während der Aufnahme des Abdominalbereichs eine Atemtriggerung erfolgen, oder der Patient den Atem anhalten und Peristaltikbewegungen erforderlichenfalls medikamentös unterdrückt werden; bei der MR-Aufnahme im Herzbereich sollte eine EKG-Triggerung erfolgen. Zwischen den Aufnahmen dieser Teilbereiche wird der Patiententisch in die für die Aufnahme des jeweils nächsten Teilbereichs erforderliche Position geschoben, so daß der abzubildende Bereich in der Mitte der Spulen 4 und damit im homogenen Bereich des stationären Magnetfeldes liegt; nur der Oberschenkelbereich sollte nur soweit zur Mitte hin verschoben werden, daß der Oberschenkel des Patienten von außen zugänglich ist, damit der Arzt den Katheter noch verschieben kann. Dies kann zu geometrischen Bildverzerrungen im Bereich der Oberschenkel führen (aufgrund der Inhomogenität des Magnetfeldes sowie der Gradientennichtlinearität), die jedoch nicht stören, da in diesem Bereich lediglich die Katheterbewegung verfolgt werden soll.

Während der Aufnahme dieser MR-Datensätze steht der Antrieb 6 still; die Positionen, die die Tischplatte dabei einnimmt, werden gespeichert. Die in den verschiedenen Positionen aufgenommenen Datensätze können anschließend in einem Rechner zu einem Gesamtdatensatz eines einzigen MR-Übersichtsbildes zusammengesetzt werden; es ist jedoch auch möglich, die drei MR-Bilder getrennt zu verwenden, wobei jedoch in diesem Fall eine geringfügige Überlappung der einzelnen Teilbereiche zweckmäßig ist. Da bei diesen Bildern ein relativ großer Bereich mit hoher räumlicher Auflösung abgebildet wird, ist es auch bei Anwendung von schnellen Gradientenecho- oder Spinechoverfahren zur Gewinnung der für die Bilderzeugung erforderlichen Kernresonanzsignale nicht möglich, eine für die Kontrolle der Vorschubbewegung des Katheters ausreichend schnelle Bildfolge zu erreichen.

Nachdem auf diese Weise ein Übersichtsbild des gesamten Bereiches oder mehrere Übersichtsbilder von Teilbereichen des Patienten erfolgt oder gespeichert sind, wird der in eine Oberschenkelarterie eingeführte Katheter mit einem geeigneten MR-Kontrastmittel gefüllt (z.B. GdDTPA oder eines der neu entwickelten "Blood Pool"-Kontrastmittel) - ggf. in geeigneter Lösung - und langsam vorgeschoben. Während dieses Vorschubs werden in dichter zeitlicher Folge MR-Bilder eines Zielbereiches um- und vor der Katheterspitze aufgenommen, und diese kleinen Teilbilder werden fortlaufend in das MR-Übersichtsbild eingeblendet, so daß der Eindruck einer (Röntgen-) Durchleuchtung entsteht. Da immer nur ein kleiner Zielbereich erfaßt wird, kann trotz der schnellen zeitlichen Folge dieser MR-Bilder ein ausreichendes räumliches Auflösungsvermögen erzielt werden. Dies soll im folgenden anhand der Figuren 2 bis 5 erläutert werden.

In Fig. 2 ist mit 12 die schon erwähnte Hochfrequenzempfangsspule schematisch angedeutet, die während jedes dieser MR-Bilder aus dem Untersuchungsbereich eine Anzahl von Kernresonanzsignalen aufnimmt. Diese Signale werden in einem Empfänger 13 verstärkt, mit einem Signal mit einer konstanten Frequenz gemischt, so daß sich ein Mischprodukt im Basisband ergibt, und das so erhaltene Signal wird anschließend digitalisiert. Das digitalisierte Signal wird einer Bildrekonstruktionseinheit 14 zugeführt, in der ein MR-Bild des Zielbereiches rekonstruiert wird. Dieses MR-Bild wird nun in das Übersichtbild in geometrisch richtiger Lage eingeblendet (d.h. die Datensätze des MR-Bildes und des MR-Übersichtsbildes in diesem Bereich werden miteinander kombiniert) und das auf diese Weise erzeugte Kombinationsbild wird auf einem Sichtgerät 15 wiedergegeben.

Fig. 4 zeigt schematisch den in dem Übersichtsbild abgebildeten Teil des Patienten. Die Arterien 100, die von den Oberschenkeln zum Herzen 101 verlaufen, sind dabei strichpunktiert dargestellt. In eine dieser Arterien ist ein Katheter 102 eingeführt. Dieser Katheter, der einen Innendurchmesser von 1 mm haben kann, ist der besseren Übersicht halber neben den Arterien dargestellt; selbstverständlich befindet er sich aber innerhalb der Arterie, deren Innendurchmesser wesentlich größer ist als sein Außendurchmesser. In Fig. 4 ist mit strichpunktierten Linien ein Zielbereich 103 angedeutet, der um und vor der Katheterspitze liegt, und dessen Richtung der Richtung der Katheterspitze entspricht, so daß er zumindest annähernd in Richtung des vor der Katheterspitze befindlichen Teils der Arterie verläuft. Dieser Zielbereich, der in das Übersichtsbild eingeblendet sein kann - aber nicht sein muß - ist dann derjenige Bereich des Körpers im Patienten, der durch das nächste MR-Bild abgebildet wird. Im folgenden wird nun erläutert, wie die Lage und die Ausrichtung des Zielbereichs für die nächste MR-Aufnahme bestimmt wird und wie erreicht wird, daß das nächste MR-Bild sich nur auf diesen Zielbereich bezieht.

Das in der Bildrekonstruktionseinheit 14 rekonstruierte MR-Bild des vergleichsweise kleinen Zielbereichs wird einer Bildverarbeitungseinheit 16 zugeführt, die die Katheterspitze detektiert. Da die Katheterspitze 16 mit einem Kontrastmittel gefüllt ist und eine langgestreckte Form hat, ist es vergleichsweise einfach, in dem MR-Bild diejenige (durch eine bestimmte Zeile oder Spalte des MR-Bildes bestimmte) Grenze herauszufinden, auf deren einer Seite Kontrastmittel vorhanden ist, und auf deren anderer Seite kein Kontrastmittel vorhanden ist. Diese Grenze bestimmt die Lage der Katheterspitze. Nimmt man dann noch diejenigen Pixel auf der einen Seite der Grenze hinzu, in denen sich das Katheter in der Nähe seiner Spitze abbildet, läßt sich leicht aus dem MR-Bild auch die Richtung der Katheterspitze bestimmen. Der (dreidimensionale) Zielbereich wird nun so gewählt, daß die Katheterspitze noch mit einem kleinen Teil in diesen Bereich hineinragt, und daß dieser Bereich seine Hauptausdehnungsrichtung in Richtung des Katheters hat, weil sich die Arterie in der näheren Umgebung der Kathetespitze zumindest annähernd in der Richtung des Katheters erstrecken wird. Diese Hauptausdehnung des Zielbereichs muß genügend lang sein (z.B. 64 mm), um sicherzustellen, daß auch bei einem schnellen Vorschub des Katheters die Katheterspitze bei dem nächsten MR-Bild mit Sicherheit noch in diesem Zielbereich abgebildet wird. Auch senkrecht zu dieser Richtung sollte der Zielbereich Abmessungen haben, die ein Verbleiben der Katheterspitze in dem Zielbereich während des MR-Bildes gewährleisten, beispielsweise 16 mm.

In Fig. 5 ist schematisch die Arterie 100, das darin befindliche Katheter 102 und der zugehörige Zielbereich 103 dargestellt. Die Hauptausdehnungsrichtung ist mit R3 und die beiden anderen, dazu senkrechten Richtungen mit R2 und R1 bezeichnet, wobei R1 die zur'Tischplatte senkrechte Richtung (in Fig. 1 ist das die x-Richtung) darstellen möge.

Die Lage und die Ausrichtung (erforderlichenfalls auch die Größe) des Zielbereichs für das nachfolgende MR-Bild wird in einer Steuereinheit 17 aus der von der Bildverarbeitungseinheit 16 anhand des vorangehenden MR-Bildes ermittelten Lage und Richtung der Kathederspitze bestimmt. Die Steuereinheit steuert die Ströme für die Hochfrequenzspule 11 und für die Gradientenspulen 3,5 und 7 so, daß bei dem nachfolgenden MR-Bild Kernresonanzsignale nur aus dem zuvor berechneten Zielbereich gewonnen werden können.

Der zeitliche Verlauf der von den Gradientenspulen 3, 5 und 7 erzeugten magnetischen Gradientenfelder wird von einem Gradienten-Wellenform-Generator 20 bestimmt, der von der Steuereinheit 17 in Abhängigkeit von der für das nächste MR-Bild vorgegebenen Lage und Ausrichtung des Zielbereichs 103 gesteuert wird. Bei den bekannten MR-Geräten ist in einem solchen Generator in der Regel eine feste Zahl von zuvor berechneten Wellenformen gespeichert von denen jeweils eine auswählbar ist. Bei der Erfindung kann hingegen die Berechnung des zeitlichen Verlaufs der magnetischen Gradientenfelder erst nach Auswertung des vorangegangenen MR-Bildes in der Einheit 16 erfolgen. Die in der Einheit 20 berechnete Wellenform wird mindestens einem der Gradientenverstärker 21,22 und 23 zugeführt, die den Strom für die Gradientenspulen 3,5 und 7 liefern. Die Verstärkungsfaktoren der Gradientenverstärker 21,22 und 23 sind durch die Steuereinheit 17 unabhängig voneinander einstellbar.

Wenn die Richtung des magnetischen Gradientenfeldes ausnahmsweise mit einer der drei Richtungen x,y oder z zusammenfällt, wird das magnetische Gradientenfeld nur von der Gradientenspulenanordnung für die betreffende Richtung erzeugt(die Verstärkungsfaktoren für die Gradientenverstärker, die die beiden anderen Gradientenspulen speisen, werden dann auf Null gesetzt). In allen anderen Fällen wird das magnetische Gradientenfeld von mindestens zwei der Gradientenspulen erzeugt, in denen dann gleichzeitig Ströme mit demselben zeitlichen Verlauf, in der Regel aber unterschiedlicher Amplitude fließen, so daß die vektorielle Addition der entsprechend gewichteten Gradienten die gewünschte Gradientenrichtung ergibt.

Die Mittenfrequenz und die Umhüllende der von der Hochfrequenzspule 11 erzeugten Hochfrequenzimpulse wird von einem Generator 18 vorgegeben, der ebenfalls von der Steuereinheit 17 in Abhängigkeit von der Lage und der Richtung der Kathederspitze gesteuert wird, die von der Bildverarbeitungseinheit 16 aus dem vorangegangenen MR-Bild ermittelt wurde. Die Steuereinheit 17 steuert auch die Verstärkung eines Verstärkers 19 über den das von dem Generator 18 gelieferte Hochfrequenzsignal der Hochfrequenzsendespule 11 zugeführt wird.

Die Steuerung des zeitlichen Verlaufs der Ströme durch die Hochfrequenzsendespule 11 bzw. durch die Gradientenspulen 3,5 und 7 ergibt eine Regelschleife (Feedback-Loop), die die Optimierung bestimmter Parameter bei einem nachfolgenden MR-Bild - im Beispiel sind das Lage und Ausrichtung des Zielbereichs an 103 - gestattet.

Eine für die Gewinnung eines MR-Bildes aus dem Zielbereich 103 geeignete Sequenz könnte darin bestehen, mit drei zueinander senkrechten Hochfrequenzimpulsen die Kernmagnetisierung außerhalb von drei zueinander senkrechten (in Richtung R1, R2 und R3 verlaufenden) Schichten, deren Schnittbereich den Zielbereich bildet, anzuregen und durch ein nachgeschaltetes magnetisches Gradientenfeld zu dephasieren, so daß aus dem außerhalb des Zielbereichs liegenden Teil des Patienten zeitweilig keine Kernresonanzsignale mehr empfangen werden können. Die Kernmagnetisierung in dem Zielbereich kann dann durch schnelle Gradienten-Echosequenzen mit α-Hochfrequenzimpulsen angeregt werden, woraus sich eine schnelle Bildgebung ergibt. Diese Variante hat auch den Vorteil, daß das Blut, das sich in der Arterie mit dem Katheter 102 befindet und das bei der Gewinnung des Datensatzes für die nächste MR-Aufnahme an dem Katheter vorbei in den Zielbereich hineinfließen kann "gesättigt" ist, so daß es nicht zur Bildgebung beiträgt und die Detektion der Katheterspitze nicht erschwert.

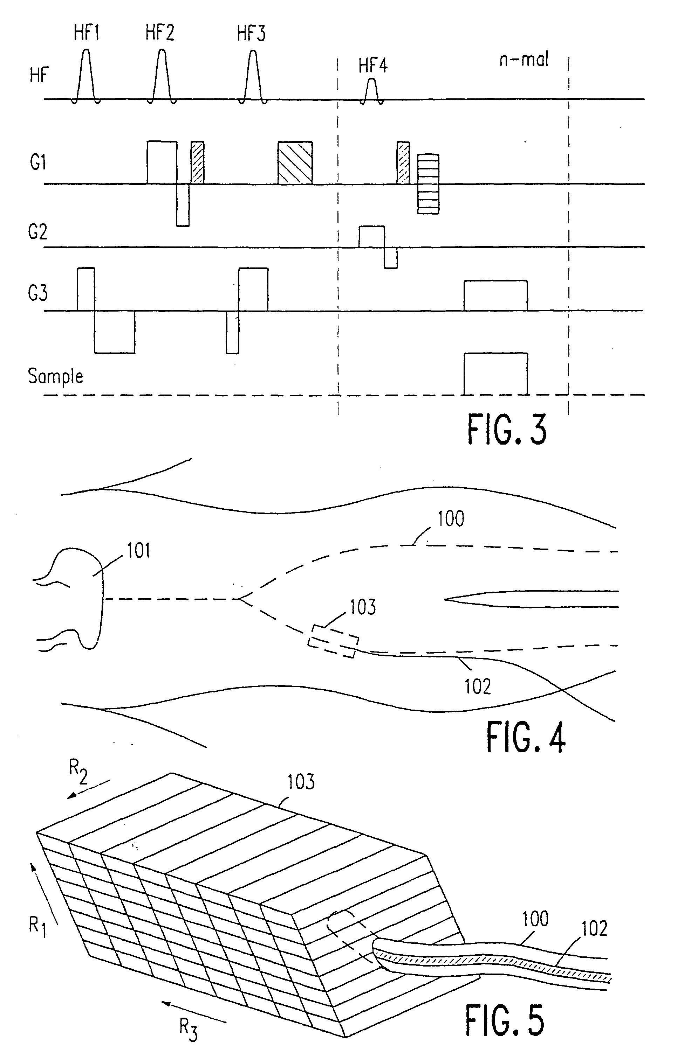

In Fig. 3 ist eine auf einem anderen Prinzip (stimuliertes Echo) beruhende Sequenz dargestellt. Die erste Zeile von Fig. 1 zeigt die zeitliche Lage der Hochfrequenzimpulse, die zweite bis vierte Zeile zeigt die während oder nach den Hochfrequenzimpulsen wirksamen magnetischen Gradientenfelder, G1, G2, G3, deren Gradient die Richtung von R1, R2 bzw. R3 in Bild 5 aufweist. In der fünften Zeile ist die zeitliche Lage des Zeitraums dargestellt, innerhalb dessen die von der Hochfrequenzempfangsspule 12 empfangenen Signale von dem Empfänger 13 verarbeitet werden.

Die Sequenz beginnt mit einem ersten 90°-Hochfrequenzimpuls HF1, der von einem magnetischen Gradientenfeld G3 begleitet wird, dessen Gradient in Richtung R3 (vgl. Fig.5) verläuft. Die Mittenfrequenz des Hochfrequenzimpulses HF1, die Größe des Gradienten des magnetischen Gradientenfeldes G3 und dessen zeitlicher Verlauf sind so gewählt, daß eine Anregung und anschließende Dephasierung der Kernmagnetisierung in einer Schicht erfolgt, die senkrecht zur Richtung R3 verläuft und die sich an das dem Oberschenkel zugewandte Ende des Zielbereichs 103 anschließt. Dadurch wird die Kernmagnetisierung in dem in dieser Schicht befindlichen Blut in der Aterie 100 desphasiert. Wenn dieses Blut anschließend an der Katheterspitze vorbei in den Zielbereich 103 einströmt, liefert es keinen Beitrag mehr zur Kernmagnetisierung, was die Detektion der Katheterspitze durch die Einheit 16 erleichtert.

Anschließend wird ein zweiter 90°-Hochfrequenzimpuls HF2 erzeugt, der von einem magnetischen Gradientenfeld G1 begleitet wird. Durch diesen schichtselektiven Hochfrequenzimpuls wird die Kernmagnetisierung in einer 16 mm dicken und senkrecht zur Richtung R1 verlaufenden Schicht angeregt, jedoch ist mit diesem schichtselektiven Impuls keine anschließende Dephasierung der Kernmagnetisierung verbunden - wie beim Hochfrequenzimpuls HF1. Nach dem Hochfrequenzimpuls HF2 und vor dem nächsten Hochfrequenzimpuls wird ein magnetisches Gradientenfeld G1 mit in Richtung R1 verlaufendem Gradienten eingeschaltet, ein sogenannter "Spoiler". Der Spoiler dient dazu, die FID-Signale zu unterdrücken, die durch den zweiten Hochfrequenzimpuls HF2 hervorgerufen werden.

Danach folgt ein dritter 90°-Hochfrequenzimpuls HF3, der wiederum von einem magnetischen Gradientenfeld G3 begleitet wird. Die Stärke des Gradienten G3 während des Hochfrequenzimpulses, die Mittenfrequenz des Hochfrequenzimpulses und seine Bandbreite sind so gewählt, daß die Kernmagnetisierung in einer Schicht angeregt wird, die senkrecht zur Hauptausdehnungsrichtung R3 des Zielbereichs 103 verläuft und diesen beidseitig begrenzt. Diese Schicht kann eine Dicke von z.B. 64 mm haben.

Nach dem Hochfrequenzimpuls HF3 folgt ein weiterer Spoiler, d.h. ein magnetisches Gradientenfeld mit einem in Richtung R1 verlaufenden Gradienten.

Dieser Spoiler dient dazu, daß durch HF3 hervorgerufene FID-Signal und ggf. die im Zusammenwirken zwischen HF2 und HF3 erzeugten Spin-Echo-Signale zu unterdrücken.

Schließlich folgt ein Hochfrequenzimpuls HF4. Dieser Hochfrequenzimpuls ist im Gegensatz zu den Hochfrequenzimpulsen HF1...HF3 jedoch kein 90°-Hochfrequenzimpuls, sondern ein sogenannter α-Hochfrequenzimpuls, der einen wesentlich kleineren Flip-Winkel aufweist. Durch diesen Hochfrequenzimpuls wird in Verbindung mit einem magnetischen Gradientenfeld G2 (mit einem in Richtung R2 verlaufenden Gradienten) die Kernmagnetisierung in einer z.B. 8 mm dicken Schicht angeregt, die senkrecht zur Richtung R2 verläuft und den Zielbereich 103 in dieser Richtung beidseitig begrenzt. Somit werden durch die drei Hochfrequenzimpulse HF2, HF3 und HF4 drei zueinander senkrechte Schichten angeregt, die einen gemeinsamen Schnittbereich aufweisen, der dem Zielbereich 103 entspricht.

Nach dem Hochfrequenzimpuls HF4 wird ein weiterer Spoiler ein- und ausgeschaltet, der die gleiche Gradientenrichtung aufweist und das gleiche zeitliche Integral wie der nach dem Hochfrequenzimpuls HF2 eingeschaltete Spoiler. Dadurch wird die Wirkung des ersten Spoilers auf das durch die drei Hochfrequenzimpulse HF2...HF4 erzeugte stimulierte Echosignal kompensiert. Diesem Spoiler folgt ein Phasenkodierungsgradient, der ebenfalls in Richtung G1 verläuft und anschließend wird ein in Richtung R3, d.h. in der Hauptausdehnungsrichtung des Zielbereichs verlaufender Lesegradient G3 eingeschaltet und das während dieses Lesegradienten auftretende Kernresonanzsignal - ein stimuliertes Echosignal - wird von dem Empfänger 13 digitalisiert (5. Zeile von Fig. 3).

Die mit dem Hochfrequenzimpuls HF4 beginnende und durch gestrichelte senkrechte Linien hervorgehobene Teilsequenz wird mehrfach wiederholt, beispielsweise acht mal. Bei jeder Wiederholung wird der Phasenkodierungsgradient G1, wie gestrichelt angedeutet, um eine Stufe geändert; ansonsten bleibt die Teilsequenz unverändert.

Nach diesen Wiederholungen kann aus den durch die Digitalisierung entstandenen Datensätzen des MR-Bild des Teilbereichs 103 durch zweidimensionale Fouriertransformation rekonstruiert werden. Da die Teilsequenz nur wenige Millisekunden dauert und nur einige Male wiederholt wird, können in dichter zeitlicher Folge weitere MR-Bilder erzeugt werden, wobei sich Lage und Richtung des Zielbereiches von Bild zu Bild ändern können.

Das räumliche Auflösungsvermögen, das dabei erzielbar ist, wird u.a. durch die Zahl der Wiederholungen bestimmt, und durch die Zahl der Stützstellen, an denen das Kernresonanzsignal abgetastet und digitalisiert wird. Wenn acht Wiederholungen vorgesehen sind, und das während der Lesephase auftretende Kernresonanzsignal nach der Umsetzung in das Basisband an acht Stützstellen abgetastet und digitalisiert wird, kann die Kernmagnetisierung in 8 x 8 Voxeln des Zielbereichs 103 rekonstruiert werden. Die in Fig. 5 durch Quader angedeuteten Voxel, in denen die Kernmagnetisierung im Zielbereich rekonstruiert werden kann, haben dabei Abmessungen von 2 x 8 x 16 mm. Das Auflösungsvermögen ist in den drei Richtungen R1,R2 und R3 also unterschiedlich. Dadurch wird der Tatsache Rechnung getragen, daß auch die Katheterspitze in diesen drei Raumrichtungen ihre Lage in unterschiedlichem Maße ändert.

Das Auflösungsvermögen in der Hauptausdehnungsrichtung R3 kann dadurch verbessert werden, daß das Kernresonanzsignal während des Lesegradienten noch öfter abgetastet wird, was aber voraussetzt, daß die Amplitude und/oder die Dauer des Lesegradienten vergrößert wird. Auch das Auflösungsvermögen in Richtung R1 kann noch verbessert werden, indem die Teilsequenz öfter wiederholt und der Phasenkodierungsgradient G 1 dabei in noch mehr Stufen geändert wird; allerdings verringert sich dadurch auch die Wiederholfrequenz der MR-Bilder. Ebenso kann - unter entsprechendem Zeitverlust - eine oder mehrere Nachbarschichten in Richtung R2 zwecks höherer Auflösung abgebildet werden.

Wenn der Zielbereich 103 die Grenze zwischen den Regionen überschreitet, die bei der Erstellung der Übersichtsaufnahmen aus getrennten Positionen aufgenommen wurde, wird der Patiententisch in die nächste Position weitergefahren, so daß bezüglich der Inhomogenität des Hauptfeldes und der Nichtlinearität der magnetischen Gradientenfelder stets identische Verhältnisse wie bei der Erstellung der Übersichtsbilder herrschen.

Wenn die Katheterspitze auf diese Weise unter fortlaufender Positionskontrolle am Sichtgerät 15 am Herzen angekommen ist, kann das Kontrastmittel aus dem Katheter in die Koronararterien gespritzt werden, und es können in bekannter Weise MR-Bilder der mit Kontrastmittel gefüllten Herzarterien aufgenommen werden.

Das erfindungsgemäße Verfahren ist auch bei anderen interventionellen Untersuchungen einsetzbar, beispielsweise beim Einführen einer Glasfaseroptik in eine Körperöffnung - etwa die Speiseröhre - für die Videoendoskopie oder beim Einführen eines Operationswerkzeuges für minimale invasive Chirurgie in eine natürliche oder operativ hergestellte Körperöffnung. Mit der Spitze der Glasfaseroptik bzw. des Operationswerkzeuges muß dabei ein Gegenstand verbunden sein, der einen guten MR-Kontrast liefert, beispielsweise ein mit einem MR-Kontrastmittel gefüllter Teil eines Katheters. Der Gegenstand bzw. der Katheterteil dient in diesem Fall lediglich als Hilfsmittel für die Positionierung eines anderen Instruments (Glasfaseroptik bzw. Operationswerkzeug).

## Patentansprüche

1. MR-Verfahren, bei dem eine Vielzahl von Sequenzen mit jeweils mindestens einem Hochfrequenzimpuls und mindestens einem magnetischen Gradientenfeld auf einen Untersuchungsbereich einwirkt und bei dem aus den dabei gewonnenen MR-Signalen eine Folge von MR-Bildern rekonstruiert wird,
**dadurch gekennzeichnet,**
**daß** MR-Bilder der Folge einer automatischen Analyse unterzogen werden und daß im Sinne einer Regelschleife in Abhängigkeit von dem Analyseresultat der zeitliche Verlauf der Hochfrequenzimpulse und/oder der magnetischen Gradientenfelder für die Sequenzen eines jeweils nachfolgenden MR-Bildes der Folge verändert wird.

2. Verfahren nach Anspruch 1,
**dadurch gekennzeichnet, daß** zur Positionierung eines Gegenstandes in einem menschlichen oder tierischen Körper vor der Einführung dieses Gegenstandes mindestens ein MR-Übersichtsbild erzeugt wird, daß nach der Einführung des Gegenstandes in den Körper fortlaufend MR-Bilder eines Zielbereiches um und vor dem vorderen Ende des Gegenstandes erzeugt und mit dem MR-Übersichtsbild kombiniert werden, daß zur Ermittlung der Lage des vorderen Endes des Gegenstandes die MR-Bilder automatisch analysiert werden, daß daraus die Lage des Zielbereichs für das jeweils nachfolgende MR-Bild bestimmt und der zeitliche Verlauf der magnetischen Gradientenfelder bzw. der Hochfrequenzimpulse entsprechend gesteuert wird.

3. Verfahren nach Anspruch 2,
**dadurch gekennzeichnet, daß** der Gegenstand ein mit Kontrastmittel gefüllter Katheter ist, der in den Körper eingeführt wird.

4. Verfahren nach Anspruch 3,
**dadurch gekennzeichnet, daß** aus den MR-Bildern automatisch die Richtung der Katheterspitze ermittelt wird und daß in Abhängigkeit von dieser Richtung die Gradientenspulen zur Erzeugung der während der Einführung des Katheters wirksamen magnetischen Gradientenfelder so gesteuert werden, daß ein magnetisches Gradientenfeld entsprechend der Richtung der Katheterspitze und die anderen senkrecht dazu verlaufen.

5. Verfahren nach einem der Ansprüche 3 bis 4,
**dadurch gekennzeichnet, daß** zur Erzeugung des MR-Übersichtsbildes der Körper in wenigstens zwei definierte Positionen geschoben und das MR-Übersichtsbild aus den dabei gewonnenen MR-Teilbildern zusammengesetzt wird und daß bei der Einführung des Katheters der Körper in die gleichen Positionen geschoben wird, derart, daß die verschiedenen Körperstrukturen jeweils bei der Erfassung des MR-Teilbildes einerseits und des MR-Bildes des Zielbereiches andererseits jeweils die gleiche Position einnimmt.

6. Verfahren nach einem der Ansprüche 3 bis 5, wobei das Katheter in eine Arterie eingeführt wird,
**dadurch gekennzeichnet, daß** während des Einführens des Katheters die Kernmagnetisierung in dem Bereich hinter der Katheterspitze gesättigt wird.

7. Anordnung zur Durchführung des Verfahrens nach einem der vorhergehenden Ansprüche mit
a) einer Gradientenspulenanordnung (3,5,7) zur Erzeugung von magnetischen Gradientenfeldern in einem von einem stationären homogenen Magnetfeld durchsetzten Untersuchungsbereich,
b) einer Hochfrequenzspulenanordnung (11,12) zum Erzeugen eines hochfrequenten Magnetfeldes bzw. zum Empfang von MR-Signalen aus dem Untersuchungsbereich,
c) Mitteln zum Rekonstruieren einer Folge von MR-Bildern aus einer Anzahl von MR-Signalen
d) Mitteln zum automatischen Analysieren der MR-Bilder der Folge
e) Mitteln (17) zur Beeinflussung des zeitlichen Verlaufs der Ströme in der Gradientenspulenanordnung (3,5,7) und/oder in der Hochfrequenzspulenanordnung für die Sequenzen eines jeweils nachfolgenden MR-Bildes der Folge in Abhängigkeit von dem Analyseresultat im Sinne einer Regelschleife und
f) Mitteln zur Wiedergabe wenigstens eines MR-Bildes der Folge.

8. MR-Anordnung nach Anspruch 7,
**gekennzeichnet durch**
a) Mittel zum Erzeugen eines MR-Übersichtsbildes eines Körpers im Untersuchungsbereich,
b) Mittel zum Erzeugen von MR-Bildern eines im Vergleich zu dem MR-Übersichtsbild kleinen Zielbereichs (103),
c) Analysemittel mit einer Bildverarbeitungseinheit zur Detektion der Lage und gegebenenfalls der Richtung des vorderen Endes eines Gegenstandes in den MR-Bildern des Zielbereichs und zur Definition des Zielbereichs für das nachfolgende MR-Bild in Abhängigkeit von der detektierten Lage und gegebenenfalls der Richtung des Katheters,
d) Mitteln zur Steuerung der Gradientenspulenanordnung und der Hochfrequenzspulenanordnung derart, daß bei dem nachfolgenden MR-Bild im wesentlichen nur die Kernmagnetisierung aus dem Zielbereich zur Bildgebung beiträgt,
e) Mitteln (14) zum fortlaufenden Einfügen der MR-Bilder des jeweiligen Zielbereichs in das MR-Übersichtsbild und Mitteln zur Wiedergabe des daraus resultierenden MR-Bildes.

## Claims

1. An MR method in which a plurality of sequences, each comprising at least one RF pulse and at least one magnetic gradient field, act on an examination zone and a series of MR images is reconstructed from the MR signals thus acquired, **characterized in that** MR images of the series are subjected to an automatic analysis and that, in the sense of a control loop, the variation in time of the RF pulses and/or the magnetic gradient fields for the sequences of each time a subsequent MR image is varied in dependence on the analysis result.

2. A method as claimed in Claim 1, **characterized in that** for the positioning of an object in a human or animal body at least one MR survey image is formed before the introduction of the object, that after the introduction of the object into the body MR images of a target region around and in front of the object are continuously formed and combined with the MR survey image, that for the determination of the position of the front end of the object the MR images are automatically analyzed, that on the basis thereof the position of the target region for the respective next MR image is determined, and that the variation in time of the magnetic gradient fields or the RF pulses is controlled accordingly.

3. A method as claimed in Claim 2, **characterized in that** the object is a catheter filled with contrast medium and introduced into the body.

4. A method as claimed in Claim 3, **characterized in that** the direction of the catheter tip is automatically determined from the MR images and that the gradient coils for generating the magnetic gradient fields active during the introduction of the catheter are controlled in dependence on this direction so that one magnetic gradient field extends in the direction of the catheter tip whereas the other fields extend perpendicularly thereto.

5. A method as claimed in one of the Claims 3 to 4, **characterized in that** for the generating of the MR survey image the body is moved to at least two defined positions, that the MR survey image is composed from the MR sub-images thus acquired, and that during the introduction of the catheter the body is moved to the same positions so that the various body structures occupy the same position during acquisition of the MR sub-image as well as during acquisition of the MR image of the target region.

6. A method as claimed in one of the Claims 3 to 5, in which the catheter is introduced into an artery, **characterized in that** during the introduction of the catheter the nuclear magnetization in the region behind the catheter tip is saturated.

7. An apparatus for carrying out the method claimed in one of the preceding Claims, comprising
a) a gradient coil system (3, 5, 7) for generating magnetic gradient fields in an examination zone which is traversed by a steady, uniform magnetic field,
b) an RF coil system (11, 12) for generating an RF magnetic field and for receiving MR signals from the examination zone,
c) means for reconstructing a series of MR images from a number of MR signals,
d) means for analyzing the MR images of the series,
e) means (17) for influencing the variation in time of the currents in the gradient coil system (3, 5, 7) and/or in the RF coil system for the sequences of each time a subsequent MR image in dependence on the analysis result, and
f) means for displaying at least one MR image, of the series.

8. An MR apparatus as claimed in Claim 7, **characterized in that** it comprises
a) means for generating an MR survey image of a body in the examination zone,
b) means for generating MR images of a target region (103) which is small in comparison with the MR survey image,
c) analysis means which include an image processing unit for detecting the position and possibly the direction of the front end of an object in the MR images of the target region, and for defining the target region for the next MR image in dependence on the detected position and possibly the direction of the catheter,
d) means for controlling the gradient coil system and the RF coil system so that in the next MR image essentially only the nuclear magnetization from the target region contributes to imaging,
e) means (14) for continuously mapping the MR images of the relevant target region in the MR survey image and means for displaying the MR image resulting therefrom.

## Revendications

1. Procédé R.M.N. dans lequel plusieurs séquences avec, respectivement, au moins une impulsion à haute fréquence et au moins un champ à gradient magnétique agissent sur une zone d'examen et dans lequel une séquence d'images R.M.N. est reconstruite à partir des signaux R.M.N. ainsi obtenus, **caractérisé en ce que** des images R.M.N. sont soumises à la succession d'une analyse automatique et que le tracé temporel des impulsions à haute fréquence et/ou des champs à gradient magnétiques est modifié en fonction du résultat de l'analyse dans le sens d'une boucle de réglage pour les séquence d'une image R.M.N. respectivement suivante.

2. Procédé selon la revendication 1, **caractérisé en ce que**, pour le positionnement d'un objet dans un corps humain ou animal, au moins une vue d'ensemble R.M.N. est produite avant l'introduction de cet objet, qu'après l'introduction de l'objet dans le corps, des images R.M.N. d'une zone ciblée sont produites autour et devant l'extrémité antérieure de l'objet et sont combinées avec la vue d'ensemble R.M.N., que les images R.M.N. sont analysées automatiquement pour la détermination de la position de l'extrémité antérieure de l'objet, que la position de la zone ciblée pour l'image R.M.N, respectivement suivante est déterminée à partir de là et le tracé temporel des champs à gradient magnétiques ou des impulsions à haute fréquence est commandé en conséquence.

3. Procédé selon la revendication 2, **caractérisé en ce que** l'objet est un cathéter rempli de produit de contraste qui est introduit dans le corps.

4. Procédé selon la revendication 3, **caractérisé en ce que** l'orientation de la pointe du cathéter est déterminée automatiquement à partir des images R.M.N. et qu'en fonction de cette orientation, les bobines à gradient sont commandées pour la production des champs à gradient magnétiques actifs pendant l'introduction du cathéter de telle sorte qu'un champ à gradient magnétique s'étende selon la direction de la pointe du cathéter et que les autres s'étendent perpendiculairement à celui-ci.

5. Procédé selon l'une des revendications 3 à 4, **caractérisé en ce que**, pour la production de la vue d'ensemble R.M.N., le corps est déplacé dans au moins deux positions définies et la vue d'ensemble R.M.N. est composée à partir des images partielles R.M.N. ainsi obtenues et que, lors de l'introduction du cathéter, le corps est déplacé dans les mêmes positions de telle sorte que les différentes structures du corps adoptent respectivement la même position lors de la saisie de l'image partielle R.M.N., d'une part, et de l'image R.M.N. de la zone ciblée, d'autre part.

6. Procédé selon l'une des revendications 3 à 5, le cathéter étant introduit dans une artère, **caractérisé en ce que**, pendant l'introduction du cathéter, la magnétisation nucléaire est saturée dans la zone derrière la pointe du cathéter.

7. Dispositif de mise en oeuvre du procédé selon l'une des revendications précédentes avec:
a) un montage de bobines à gradient (3, 5, 7) pour la production de champs à gradient magnétiques dans une zone d'examen traversée par un champ magnétique homogène stationnaire;
b) un montage de bobines à haute fréquence (11, 12) pour la production d'un champ magnétique à haute fréquence ou pour la réception de signaux R.M.N. à partir de la zone d'examen;
c) des moyens pour la reconstruction d'une séquence d'images R.M.N. à partir de plusieurs signaux R.M.N.;
d) des moyens pour l'analyse automatique des images R.M.N. de la séquence;
e) des moyens (17) pour influencer le tracé temporel des courants dans le montage de bobines à gradient (3, 5, 7) et/ou dans le montage de bobines à haute fréquence pour les séquences d'une image R.M.N. respectivement suivante de la séquence en fonction du résultat de l'analyse dans le sens d'une boucle de réglage et
f) des moyens pour la reproduction d'au moins une image R.M.N. de la séquence.

8. Dispositif R.M.N. selon la revendication 7, **caractérisé par**
a) des moyens de production d'une vue d'ensemble R.M.N. d'un corps dans la zone d'examen;
b) des moyens de production d'images R.M.N. d'une petite zone ciblée par rapport à la vue d'ensemble R.M.N.;
c) des moyens d'analyse avec une unité de traitement d'images pour la détection de la position et, éventuellement, de la direction de l'extrémité antérieure d'un objet dans les images R.M.N. de la zone ciblée et pour la définition de la zone ciblée pour l'image R.M.N. suivante en fonction de la position détectée et, éventuellement, de la direction du cathéter;
d) des moyens de commande du montage de bobines à gradient et du montage de bobines à haute fréquence de telle sorte que, pour l'image R.M.N. suivante, seule la magnétisation nucléaire de la zone ciblée contribue essentiellement à la formation de l'image;
e) des moyens pour l'intégration continue des images R.M.N. de la zone ciblée respective dans la vue d'ensemble R.M.N. et des moyens de reproduction de l'image R.M.N. en résultant.
